# EUROPÄISCHE PATENTANMELDUNG

(11) **EP 1 363 483 A2**
(43) Veröffentlichungstag der Anmeldung: **19.11.2003**
(21) Anmeldenummer: 03010758.5
(22) Anmeldetag: 14.05.2003
(51) Int. Cl.: H05K 3/06, H05K 1/02

(54) **Mehrlagen-Leiterplatten-Verbundkörper sowie Verfahren zu dessen Herstellung**

(30) Priorität: 14.05.2002 DE 10221553
(71) Anmelder: rotra Leiterplatten Produktions- und Vetriebs-GmbH, 90471 Nürnberg (DE)
(72) Erfinder: Opitz, Rudi Walter, 90522 Oberasbach (DE); Stuckmann, Walter Paul Fritz, 90513 Zirndorf (DE); Kopf, Reinhold, 90461 Nürnberg (DE)
(74) Vertreter: Rau, Albrecht

(57) **Zusammenfassung**

Verfahren zur Herstellung eines Mehrlagen-Leiterplatten-Verbundkörpers umfassend die folgenden Schritte:
- Bereitstellen eines Leiterplatten-Rohlings (1), welcher aufweist eine Trägerplatte (2) und mindestens eine zur Führung von Leistungsströmen hinsichtlich der Dicke geeignete, elektrisch leitende, mit der Trägerplatte (2) flächig verbundene Leitungsschicht (3) und
- Reduktion der Dicke eines Teils der mindestens einen Leitungsschicht (3) zur Schaffung einer Signal-Leitungsschicht (8).

## Beschreibung

Die Erfindung betrifft einen Mehrlagen-Leiterplatten-Verbundkörper für integrierte Hochstrom- und Signalstrom-Anwendungen sowie ein Verfahren zu dessen Herstellung.

Im Automobilbereich wird zunehmend Leistungselektronik eingesetzt, um die Umweltverträglichkeit, die Leistungsfähigkeit, die Sicherheit und den Komfort der Kraftfahrzeuge zu erhöhen. Als Beispiele seien beheizte Katalysatoren, Start-Stopp-Funktionen, Standautomatisierungen und aktive Fahrwerke genannt. Zur Erreichung dieser Ziele müssen mechatronische Systeme eingesetzt werden, mit denen über das 12 Volt/42 Volt Bordnetz und Hochleistungs-Netzteile benötigte Leistungen bedarfsgerecht und mit einem hohen Wirkungsgrad zur Verfügung gestellt werden, wobei Ströme von mehr als 600 A gehandhabt werden müssen. Die erforderlichen Leiterplatten müssen deshalb die Fähigkeit besitzen, hohe Ströme für hohe Leistungen und gleichzeitig geringe Ströme mit schnellen Taktzeiten für Signale zu transportieren.

In der Vergangenheit haben sich zwei verschiedene Lösungen dieses Problems herausgebildet. Bei einer Lösung werden zwei Schaltkreise auf zwei getrennten Leiterplatten vorgesehen. Die beiden getrennten Leiterplatten müssen dann über mechanische Verbindungssysteme, wie z. B. Long- und Short-Stiftverbindungen und die Schwall-Löttechnik, verbunden werden. Dies ist teuer und platzaufwendig. Bei der anderen Lösung wird auf einer Leiterplatte, z. B. auf der Oberseite, der Signalschaltkreis untergebracht. Auf der anderen Seite der Leiterplatte wird der Leistungsschaltungskreis untergebracht. Die Verbindung der zwei Schaltkreise wird über mechanische Short-Stiftverbindungen und Schwall-Löten erreicht, da die Löcher nicht durchmetallisiert sind. Auch diese Lösung ist kostenaufwendig.

Der Erfindung liegt die Aufgabe zugrunde, einen Mehrlagen-Leiterplatten-Verbundkörper sowie ein Verfahren zu dessen Herstellung zu schaffen, auf dem elektronische Signalschaltungen und Leistungsschaltungen möglichst kompakt integriert sind.

Die Aufgabe wird durch die Merkmale der Patentansprüche 1 und 11 gelöst. Der Kern der Erfindung besteht darin, einen Leiterplatten-Rohling mit einer Trägerplatte vorzusehen, wobei auf mindestens einer Seite der Trägerplatte eine Dickkupfer-Leitungsschicht vorgesehen ist. In einem Ätzprozess wird ein Teil der Leitungsschicht, z. B. die Hälfte hinsichtlich der Dicke soweit reduziert, dass die Voraussetzungen zur Schaffung von Signalschaltkreisen gegeben sind. Bei diesem ersten Ätzprozess werden die Strukturen des Signalschaltkreises noch nicht geschaffen, jedoch die der Leistungsschaltkreise.

Weitere vorteilhafte Ausgestaltungen der Erfindung ergeben sich aus den Unteransprüchen.

Zusätzliche Merkmale und Einzelheiten der Erfindung ergeben sich aus der Beschreibung eines Ausführungsbeispiels anhand der Zeichnungen. Es zeigen:
Fig. 1 einen ersten Verfahrensschritt des erfindungsgemäßen Verfahrens zur Herstellung eines Mehrlagen-Leiterplatten-Verbundkörpers,
Fig. 2 einen zweiten Verfahrensschritt des erfindungsgemäßen Verfahrens,
Fig. 3 einen dritten Verfahrensschritt des erfindungsgemäßen Verfahrens,
Fig. 4 einen vierten Verfahrensschritt des erfindungsgemäßen Verfahrens,
Fig. 5 einen fünften Verfahrensschritt des erfindungsgemäßen Verfahrens,
Fig. 6 einen sechsten Verfahrensschritt des erfindungsgemäßen Verfahrens,
Fig. 7 einen siebten Verfahrensschritt des erfindungsgemäßen Verfahrens,
Fig. 8 einen achten Verfahrensschritt des erfindungsgemäßen Verfahrens,
Fig. 9 einen neunten Verfahrensschritt des erfindungsgemäßen Verfahrens,
Fig. 10 einen zehnten Verfahrensschritt des erfindungsgemäßen Verfahrens, und
Fig. 11 einen elften Verfahrensschritt des erfindungsgemäßen Verfahrens.

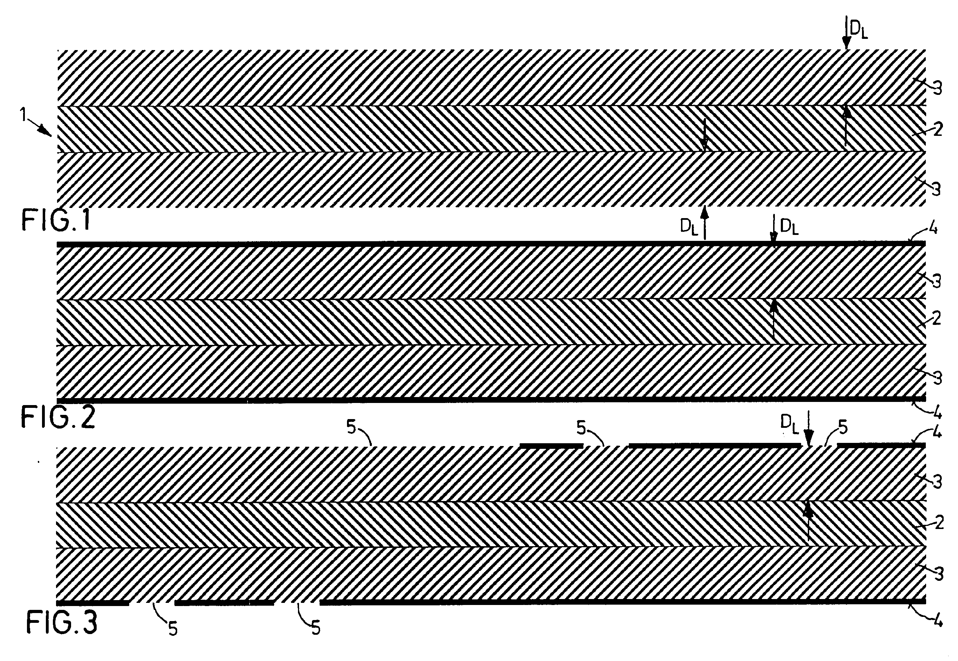

Im Folgenden wird unter Bezugnahme auf die einzelnen Verfahrensschritte die Herstellung eines Mehrlagen-Leiterplatten-Verbundkörpers beschrieben. Gemäß einem ersten Verfahrensschritt wird von einem in Figur 1 dargestellten Leiterplatten-Rohling 1 ausgegangen. Dieser weist eine elektrisch isolierende Trägerplatte 2, die aus einem sogenannten Prepreg, insbesondere einem Prepreg vom Typ FR4, besteht, auf. Die Trägerplatte 2 besteht somit aus einem mit Epoxydharz getränkten Glasgewebe. Auf der Oberseite und auf der Unterseite der Trägerplatte 2 ist jeweils flächig eine Leitungsschicht 3 befestigt. Die Leitungsschicht 3 kann auch nur auf einer Seite der Trägerplatte 2 vorgesehen sein. Die Leitungsschicht 3 besteht vorzugsweise aus Kupfer und weist eine Dicke D_{L} auf für die gilt: 150 µm ≤ D_{L} ≤ 600 µm, insbesondere 210 µm ≤ D_{L} ≤ 400 µm, besonders vorteilhaft D_{L} ≈ 400 µm. Die Leiterplatten-Rohlinge 1 sind zum Teil im Handel erhältlich. Sie können auch durch Verpressen von zwei entsprechend dicken Leitungsschichten 3 mit einer Trägerplatte 2 erzeugt werden.

Gemäß einem zweiten, in Figur 2 dargestellten Verfahrensschritt wird auf den jeweils außenliegenden Oberflächen der beiden Leitungsschichten 3 eine Schicht eines UV-Fotofeststoffresists 4 aufgetragen. Hierbei handelt es sich um eine UV-Licht empfindliche Folie, die auf die Leitungsschichten 3 auflaminiert wird.

Gemäß einem dritten, in Figur 3 dargestellten Verfahrensschritt wird der Fotoresist 4 zur Bildung der entsprechenden Leiterbahnstrukturen belichtet und anschließend entwickelt, sodass, wie in Figur 3 dargestellt, Bereiche 5 verbleiben, bei denen die Leitungsschicht 3 nicht durch Fotoresist 4 bedeckt ist.

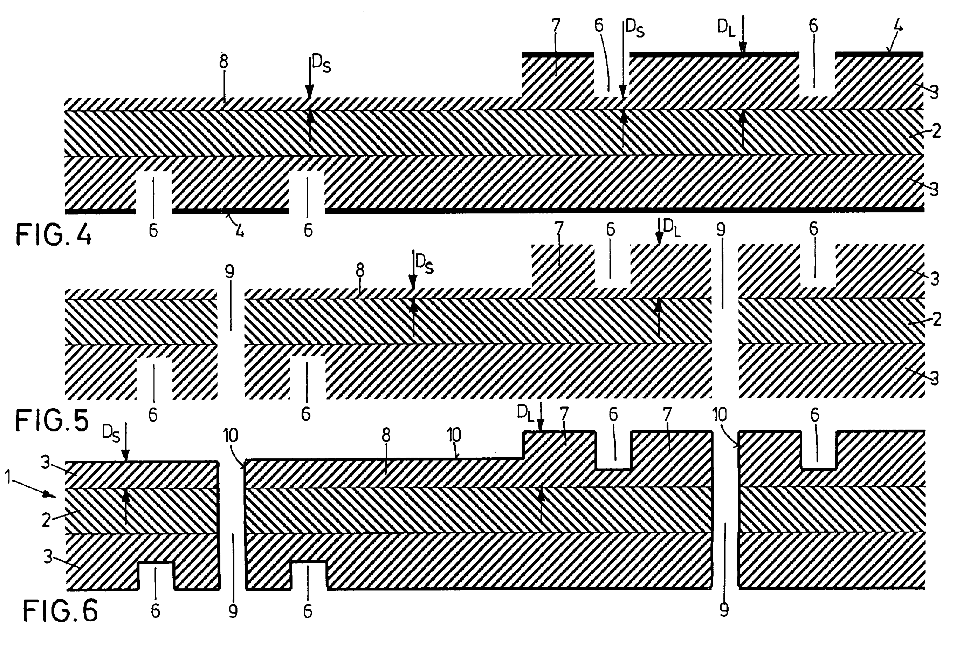

Gemäß einem vierten, in Figur 4 dargestellten Verfahrensschritt wird ein Ätzprozess durchgeführt, durch den die Leitungsschichten 3 bei den Bereichen 5 auf eine Dicke D_{S} heruntergeätzt werden. Für D_{S} gilt: 10 µm ≤ D_{S} ≤ 150 µm, insbesondere 35 µm ≤ D_{S} ≤ 105 µm, besonders vorteilhaft D_{S} ≈ 35 µm. Hierdurch entstehen Gräben 6, die die Leistungs-Leiterbahnen 7 begrenzen und am Grund noch eine Schicht Kupfer der Dicke D_{S} aufweisen. Entlang eines Bereichs, in Figur 4 die linke Hälfte der oberen Leitungsschicht 3, entsteht eine Signal-Leistungsschicht 8 einer einheitlichen Dicke D_{S}. Vorteilhafterweise ist die Signal-Leitungsschicht 8 rechteckig und nimmt einen vorgegebenen Teil, z. B. die Hälfte oder ein Drittel der Leitungsschicht, ein. Die Signal-Leitungsschicht 8 dient der späteren Ausbildung der Signalschaltkreise 15. Als Ätzmedium kann saures Kupfer(II)Chlorid, saures Eisen(III)Chlorid oder alkalischer Ammoniak verwendet werden. Durch den beschriebenen Ätzprozess erfolgt die Strukturierung der Leistungs-Leiterbahnen 7 mit einer Dicke D_{L}. Ferner erfolgt gleichzeitig die Schaffung einer noch unstrukturierten Signal-Leitungsschicht 8 einer Dicke D_{S}.

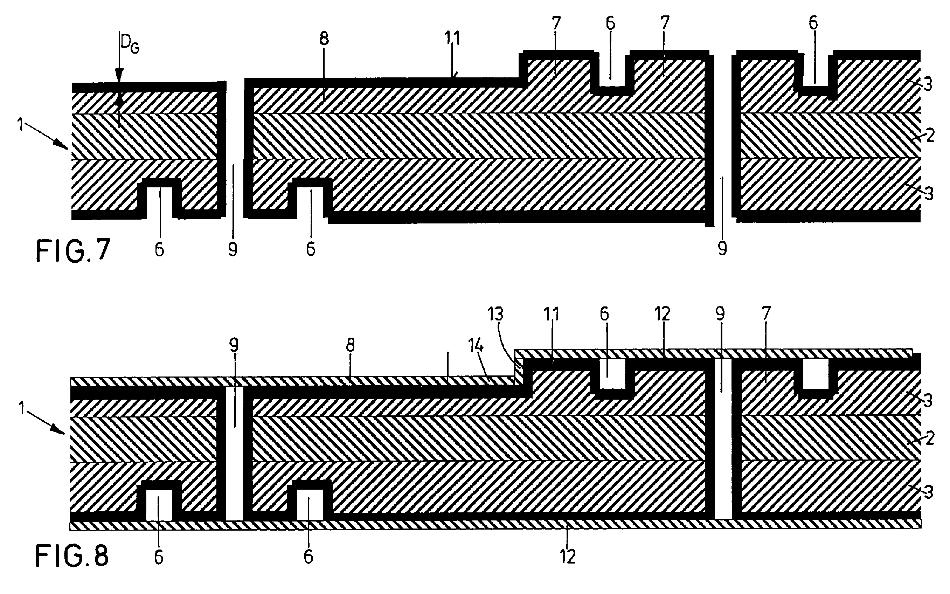

Gemäß einem fünften, in Figur 5 dargestellten Verfahrensschritt wird der Fotoresist 4 entfernt. Im Anschluss daran erfolgt das Bohren von Durchkontaktier-Löchern 9, die durch die Trägerplatte 2 und die beiden Leitungsschichten 3 verlaufen. Das Bohren kann durch ein Standard-CNC-Bohrverfahren durch CNC-Bohrautomaten erfolgen. Es ist auch möglich, die Löcher 9 durch ein Wasserstrahl-Bohrverfahren zu erzeugen.

Gemäß einem sechsten, in Figur 6 dargestellten Verfahrensschritt erfolgt eine Durchkontaktierung der Löcher 9. Dies bedeutet, dass auf den Wänden der Löcher eine Polymer-Leitschicht 10 abgeschieden wird. Die Leitschicht 10 überzieht aufgrund des eingesetzten Verfahrens selektiv die gesamte Oberfläche der Löcher 9 des Leiterplatten-Rohlings 1 gemäß dem fünften Verfahrensschritt. Die Leitschicht 10 wird nach dem DMSE-(Direct-Metallisation-System-Experience) Polymer-Leitschichtverfahren aufgebracht.

Alternativ kann ein Polymer-Durchkontaktierungsverfahren verwendet werden. Es kann auch ein stromloses chemisches Kupferdurchkontaktierungsverfahren verwendet werden, bei dem dann eine Metallschicht 10 auf der gesamten Oberfläche abgeschieden wird. Alternativ kann auch ein Carbon-Blackhole-Durchkontaktierungs-Verfahren verwendet werden. Die Prozesse können sowohl in horizontalen Durchlaufanlagen als auch in vertikalen Durchlaufanlagen durchgeführt werden. Im Fall der chemischen Verkupferung wird auf der gesamten Oberfläche des Leiterplatten-Rohlings 1 eine Metallschicht abgeschieden. Im Fall der Beschichtung nach dem DMSE-Verfahren wird eine Leitschicht nur in den Löchern 9 erzeugt.

Gemäß einem siebten, in Figur 7 dargestellten Verfahrensschritt wird auf der Metallschicht 10 eine leitende, insbesondere aus Kupfer bestehende Überzugsschicht 11 abgeschieden. Die Schicht 11 weist eine Dicke D_{G} auf für die gilt: D_{G} ≈ 25 µm. Dieser als Panel-Plating bezeichneter Vorgang erfolgt durch galvanische Verkupferung der Leitschicht 10. Hierdurch erfolgt ein Aufbau von vorzugsweise 25 µm Kupfer, bei Bedarf auch 50 µm Kupfer oder 100 µm Kupfer.

Alternativ kann auch eine 100-%ig galvanische Metallisierung der gesamten vorstrukturierten Leiterplatte erfolgen. Hierbei erfolgt ein Aufbau von vorzugsweise 25 µm Kupfer, bei Bedarf 50 µm oder 100 µm Kupfer. Im Anschluss daran erfolgt ein Aufbau von vorzugsweise 4 µm Zinn, bei Bedarf 1 µm bis 20 µm Zinn.

Gemäß einem achten, in Figur 8 dargestellten Verfahrensschritt wird ein Fotoresist 12 in Form einer Folie auf beide außenseitigen Oberflächen des Leiterplatten-Rohlings auflaminiert. Bei dem Fotoresist 12 handelt es sich um eine Tenting-Festresistfolie als Ätzresist. Die Folie wird durch Walzen auflaminiert. Durch das Fotoresist 12 werden auch die Bohrungen 9 verschlossen. Entlang der Übergangskante 13 zwischen der Signal-Leitungsschicht 8 und der angrenzenden Dickkupferschicht der Dicke D_{L} erfolgt das Auflaminieren der Fotoresistfolie häufig nicht perfekt. Von der Übergangskante 13 erstreckt sich ein beispielsweise 10 mm breiter Übergangsbereich 14 in Richtung auf die Signal-Leitungsschicht 8. Zumindest außerhalb des Übergangsbereiches, d. h. in Figur 8 links davon und rechts von der Übergangskante 13, ist sichergestellt, dass die Fotoresistfolie 12 vollständig auflaminiert ist. Vorzugsweise sollten die Löcher 9 maximal einen Durchmesser von 5 mm haben, damit eine fehlerfreie Überdeckung der Löcher 9 möglich ist.

Alternativ kann anstelle des Auflaminierens einer Fotoresistfolie auch eine Positiv-Fotolack-Technik verwendet werden. Es können elektrophoretisch applizierte ED-Fotolacke oder flüssige Fotolacke verwendet werden. Die Applikation erfolgt im Gieß- bzw. Sprühverfahren. Die Schichtdicken betragen 2 bis 10 µm, bevorzugt 6 µm. Hierbei werden die Fotolacke als Ätzresist auf der gesamten Oberfläche aufgetragen und in einem UV-Belichtungsprozess mittels tiefgezogener Negativ-Fotomasken strukturiert. Vorteilhaft hieran ist, dass der Durchmesser der Durchkontaktierungs-Löcher unbegrenzt groß sein kann, da die Fotolacke die unbelichteten Lochwandungen ätzresistent überziehen.

Alternativ ist ferner eine Laser-Direkt-Strukturierung möglich. Diese geht von einer elektrophoretischen Fotolackbeschichtung aus. Hierbei erfolgt ein Abscheiden eines ED-Positiv-Fotolackes mit einer Schichtdicke von 2 bis 10 µm, bevorzugt 6 µm. Alternativ ist auch die Abscheidung eines Flüssig-Fotolackes durch Sprühen, Gießen oder Tauchen als Ätzresist auf der gesamten Oberfläche möglich. Anschließend erfolgt ein Direkt-Belichtngsprozeß mittels UV-Laser. Alle Durchkontaktierungsbohrungen, Leistungs-Leiterbahnen der Dicke D_{L} und die Signalleiterbahnen der Dicke D_{S} sind vollständig mit ätzresistentem Fotolack beschichtet. Auch hier kann der Durchmesser der Durchkontaktierungs-Löcher unbegrenzt groß sein, da der unbelichtete Positiv-ED-Resist die Lochwandungen vollständig bedeckt. Darüber hinaus ist nicht wie bei der Aufflaminierung der Fotoresistfolie 12 die Schaffung eines Übergangsbereichs 14 erforderlich. Bei der Laser-Direktbelichtung können Signal-Feinstrukturen und Leistungsstrukturen der Dicke D_{L} im Layout beliebig platziert und strukturiert werden. Durch den Einsatz einer UV-Laserquelle werden selektiv die Positiv-Fotolackschichten vom Kupfer abgelöst bzw. nach einem wässrigen Entwicklungsprozess entfernt. Im anschließenden Ätzprozess wird das ungeschützte Grundkupfer vollständig bis zur Basisplatte entfernt. Die unbelichteten Fotolackschichten sind gegenüber den sauren Medien resistent und schützen die Signalschaltkreise und Leistungsschaltkreise beim Ätzprozess.

Alternativ ist eine Laser-Direkt-Strukturierung mit einem Kupfer-Zinn-Galvanik-Prozess möglich. Hierbei werden bei dem Leiterplatten-Rohling zunächst das Leiterbild strukturiert, anschließend das Leiterbild geätzt, anschließend die Durchkontaktierungs-Löcher gebohrt und anschließend die Durchkontaktierungs-Löcher durchkontaktiert. Bei der Galvanisierung wird die gesamte Leiterplattenoberfläche galvanisch verkupfert und vollflächig ein Metallresist, vorzugsweise eine 4 µm dicke Zinnschicht, aufgebracht. Mit einem UV-Laser wird der Metallresist im Bereich der gewünschten Isolationskanäle, die die Signal-Leiterbahnen und die Leistungs-Leiterbahnen voneinander trennen, abgetragen. In den freigelegten Bereichen ist ein Ätzangriff durch alkalische Ätzmittel möglich.

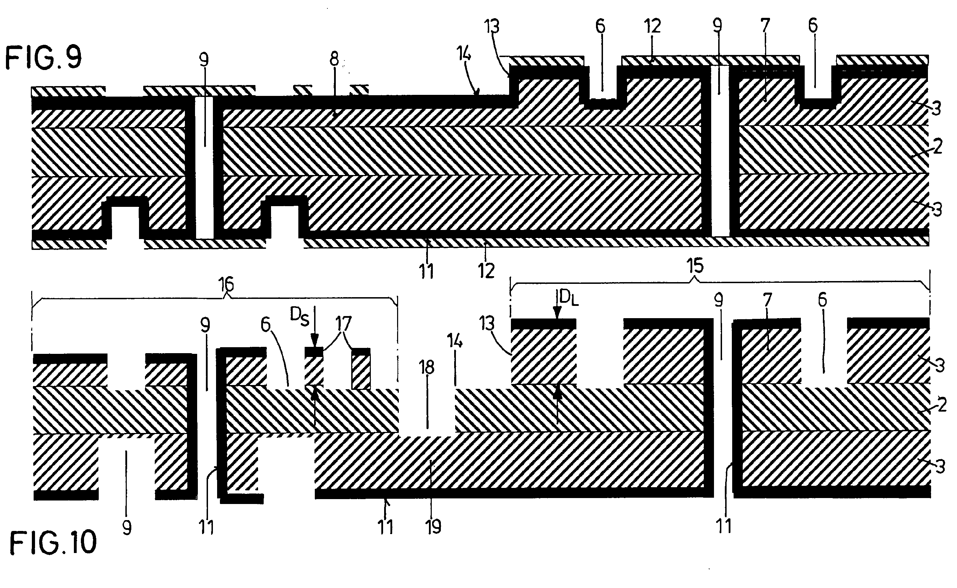

Gemäß einem neunten, in Figur 9 dargestellten Verfahrensschritt wird die Fotoresistfolie 12 belichtet und anschließend entwickelt, wodurch eine Ätzmaske entsteht. In diesem Schritt erfolgen nun somit die Vorarbeiten für eine Strukturierung der Signal-Leitungsschicht. Die Löcher 9 sind durch die Fotoresistfolie 12 weiterhin verschlossen.

Gemäß dem zehnten, in Figur 10 dargestellten Verfahrensschritt erfolgt nun ein Präzisionsprozess, bei dem das Kupfer bis zur Trägerplatte 2 im Bereich der Stellen, die nicht durch die Fotoresistfolie 12 geschützt sind, entfernt wird. Im Bereich der in Figur 10 bei der oberen Leitungsschicht 3 rechts dargestellten Hälfte entstehen nun die Leistungsschaltkreise 15 mit den Leistungs-Leiterbahnen 7 mit einer Dicke D_{L}. Jenseits des Übergangsbereichs 14, ebenfalls in der oberen Leitungsschicht 3 entstehen die Signalschaltkreise 16 mit Signal-Leiterbahnen 17. Die Leiterbahnen 7 bzw. 17 sind alle durch Gräben 6 voneinander getrennt, die bis zur Trägerplatte 2 reichen, sodass die Leiterbahnen 7 bzw. 17 voneinander isoliert sind. Als Ätzmedien kommen saures Kupfer(II)Chlorid, saures Eisen(III)Chlorid, saures Wasserstoffperoxid/Schwefelsäure oder alkalischer Ammoniak in Frage. Entlang des Übergangsbereichs 14 wird ein Biegegraben 18, der sich vorzugsweise gerade und über die volle Breite der Trägerplatte 2 erstreckt, durch die Trägerplatte 2 hindurch eingefräst, sodass die Leistungsschaltkreise 15 und die Signalschaltkreise 16 nur noch durch die dicke Kupferschicht der unteren Leitungsschicht 3 zusammengehalten werden. Dies ermöglicht es, die Leistungsschaltkreise 15 und Signalschaltkreise 16 nach dem Bestücken mit Bauteilen und Löten durch einen Biegeprozess aufeinander zu biegen, wodurch eine große Platzersparnis entsteht. Der unterhalb des Biegegrabens 18 angeordnete Abschnitt 19 der unteren Leitungsschicht 3 erstreckt sich nicht geschlossen über die gesamte Breite der Trägerplatte 2. Vielmehr sind in ihm einzelne Kontakt-Leiterbahnen ausgebildet. In Figur 10 ist eine durchgehende Kontaktbahn im Querschnitt dargestellt. Die Kontaktbahnen ermöglichen zusammen mit den durchkontaktierten Löchern 10 eine elektrische Verbindung zwischen den Leistungsschaltkreisen 15 und den Signalschaltkreisen 16. In einem sogenannten Stripp-Prozess wird der Feststoff-Fotoresist 12 bzw. der Positiv-Fotolack nach dem sauren Ätzprozess standardmäßig mittels alkalischer Strippermedien vollständig und rückstandsfrei von den Kupferoberflächen entfernt.

Alternativ kann bei der oben dargestellten Verwendung des Kupfer-Zinn-Galvanik-Prozesses die nicht geschützte Kupferschicht ebenfalls durch einen alkalischen Präzisionsätzprozess 100-%ig entfernt werden, wodurch die Leiterbahnen 7 bzw. 17 freigelegt werden. Hierfür können saure Ätzmittel nicht eingesetzt werden, da der metallische Ätzresist, Zinn, nicht säureresistent ist. Anschließend wird die Zinn-Ätzresist-Schicht durch saure Metallstripper ohne Angriffe auf das Kupfer entfernt.

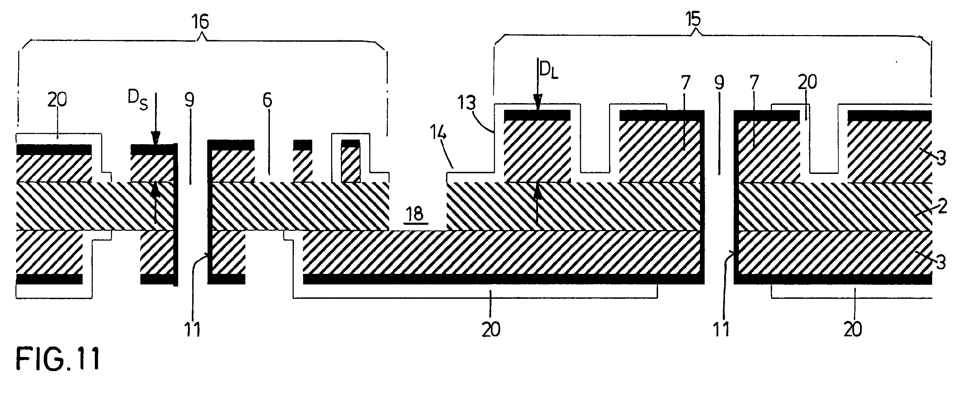

Gemäß einem elften, in Figur 11 dargestellten Verfahrensschritt erfolgt eine Beschichtung mit Löt-Stopp-Lack 20. Vorzugsweise wird Foto-Löt-Stopp-Lack verwendet. Die Applikation des Lacks wird im Sprühverfahren oder im elektrostatischen Sprühverfahren durchgeführt. Diese Verfahren ermöglichen es, dass sowohl die Leistungsschaltkreise als auch die feinen Signalschaltkreise 16 vollständig auf den Oberflächen, an den Kanten und in den Kanälen zwischen den Leiterbahnen mit Lack beschichtet werden. Aufgrund der gleichmäßigen Lackschichtdicken können auch im Bereich der Signalschaltkreise fototechnisch die geforderten feinen Löt-Stopp-Lack-Strukturen erzeugt werden. Die Endoberflächen werden standardgemäß nach dem HAL (Hot Air Leveling)-Verfahren, dem OSP (Organics Service Protection) Verfahren, einem chemischen Nickelgold-Verfahren oder einem chemischen, nicht elektrischen Zinn-Verfahren hergestellt.

Durch eine Präzisionstiefenfräsung kann bei zwei- oder mehrlagigen Leiterplatten-Verbundkörpern bei abgestimmtem Layout in 5 bis 15 mm breiten Zonen das Material der Trägerplatte 2 bis zur darunterliegenden Leitungsschicht der Dicke D_{L} entfernt werden. Im Bereich des Biegegrabens 18 kann der fertige Leiterplatten-Verbundkörper nach planaren Bestückungs- oder Lötprozessen um 90° bis 180° gebogen werden und in ein optimiertes Gehäuse eingebaut werden. Teilweise kann bis auf eine Basismaterialrestdicke von 20 bis 200 µm gefräst werden.

Durch den erfindungsgemäßen Mehrlagen-Leiterplatten-Verbundkörper entstehen zahlreiche Vorteile wie ein kleineres Volumen, ein niedrigeres Gewicht, geringere Kosten des Gesamtsystems, eine Verringerung der Systemverkabelung und Montagevorteile aufgrund der Integration von verschiedenen Baugruppen. Grundsätzlich können bei allen hier beschriebenen Verfahren Signalschaltkreise der Dicke D_{S} und Leistungsschaltkreise der Dicke D_{L} auf beiden Seiten der Trägerplatte, d. h. sowohl auf der Top-Lage als auch auf der Button-Lage vorgesehen sein. Auch ein mehrschichtiger, d. h. mehr als 3-lagiger Aufbau ist möglich. Die in den Figuren dargestellten Dicken der Schichten und Beschichtungen sind nicht maßstabsgetreu. Die Leistungsströme in den Leistungsschaltkreisen 15 betragen 1 A bis 1000 A, insbesondere 2 A bis 600 A. Die Signalströme in den Signalschaltkreisen 16 betragen 0,1 mA bis 1000 mA, insbesondere 1 mA bis 500 mA.

## Patentansprüche

1. Verfahren zur Herstellung eines Mehrlagen-Leiterplatten-Verbundkörpers umfassend die folgenden Schritte:
- Bereitstellen eines Leiterplatten-Rohlings (1), welcher aufweist eine Trägerplatte (2) und mindestens eine zur Führung von Leistungsströmen hinsichtlich der Dicke geeignete, elektrisch leitende, mit der Trägerplatte (2) flächig verbundene Leitungsschicht (3) und
- Reduktion der Dicke eines Teils der mindestens einen Leitungsschicht (3) zur Schaffung einer Signal-Leitungsschicht (8).

2. Verfahren gemäß Anspruch 1, **dadurch gekennzeichnet, dass** die mindestens eine Leitungsschicht (3) eine Dicke D_{L} aufweist, für die gilt: 150 µm ≤ D_{L} ≤ 600 µm, insbesondere 210 µm ≤ D_{L} ≤ 400 µm, besonders vorteilhaft D_{L} ≈ 400 µm.

3. Verfahren gemäß Anspruch 1 oder 2, **dadurch gekennzeichnet, dass** die Signal-Leitungsschicht (8) eine Dicke D_{S} aufweist, für die gilt: 10 µm ≤ D_{S} ≤ 150 µm, insbesondere 35 µm ≤ D_{S} ≤ 105 µm, besonders vorteilhaft D_{S} ≈ 35 µm.

4. Verfahren gemäß Anspruch 3, **dadurch gekennzeichnet, dass** die teilweise Reduktion der mindestens einen Leitungsschicht (3) unter Bildung der Signal-Leitungsschicht (8) durch einen ersten Ätzprozess erfolgt.

5. Verfahren gemäß Anspruch 4, **dadurch gekennzeichnet, dass** durch den ersten Ätzprozess außerhalb der Signal-Leitungsschicht (8) in der mindestens einen Leitungsschicht (3) Leistungs-Leiterbahnen (7) der Dicke D_{L} erzeugt werden.

6. Verfahren gemäß Anspruch 5, **dadurch gekennzeichnet, dass** zwei auf gegenüberliegenden Seiten der Trägerplatte (2) angeordnete Leitungsschichten (3) angeordnet sind.

7. Verfahren gemäß Anspruch 6, **dadurch gekennzeichnet, dass** nach dem ersten Ätzprozess Durchkontaktierungs-Löcher (9) zur Durchkontaktierung der ersten Leitungsschicht (3) mit der zweiten Leitungsschicht (3) erzeugt werden.

8. Verfahren gemäß Anspruch 7, **dadurch gekennzeichnet, dass** im Anschluss an die Ausbildung der Durchkontaktierungs-Löcher (9) eine elektrisch leitende Beschichtung zumindest auf deren Innenseite erfolgt.

9. Verfahren gemäß Anspruch 8, **dadurch gekennzeichnet, dass** in einem zweiten Ätzprozess im Bereich der Signal-Leitungsschicht (8) Signalschaltkreise (16) und außerhalb davon Leistungsschaltkreise (15) erzeugt werden.

10. Verfahren gemäß Anspruch 9, **dadurch gekennzeichnet, dass** zwischen den Leistungsschaltkreisen (15) und den Signalschaltkreisen (16) ein Übergangsbereich (14) besteht, in den ein Biegegraben (18) gefräst wird.

11. Mehrlagen-Leiterplatten-Verbundkörper hergestellt nach dem Verfahren gemäß einem der Ansprüche 1 bis 10.

12. Mehrlagen-Leiterplatten-Verbundkörper gemäß Anspruch 11 mit
a) einem Leiterplatten-Rohling (1), welcher aufweist eine Trägerplatte (2) und mindestens eine elektrisch leitende, mit der Trägerplatte (2) flächig verbundene Leistungsschicht (3),
b) wobei die mindestens eine Leitungsschicht (3) Leistungsschaltkreise (15) und Signalschaltkreise (16) aufweist.
